# EUROPEAN PATENT APPLICATION

(11) **EP 4 300 573 A1**
(43) Date of publication of application: **03.01.2024**
(21) Application number: 22759602.0
(22) Date of filing: 21.02.2022
(51) Int. Cl.: H01L 23/427, F28D 15/02, H05K 7/20

(54) **THERMAL DEVICE**

(30) Priority: 26.02.2021 JP 2021031010
(71) Applicant: Kyocera Corporation, Kyoto-shi Kyoto 612-8501 (JP)
(72) Inventor: FUJITA, Naoya, Kyoto-shi, Kyoto 612-8501 (JP); HIRANO, Yoshinori, Kyoto-shi, Kyoto 612-8501 (JP); ABE, Yuichi, Kyoto-shi, Kyoto 612-8501 (JP); NABESHIMA, Yutaka, Kyoto-shi, Kyoto 612-8501 (JP)
(74) Representative: Viering, Jentschura & Partner mbB Patent- und Rechtsanwälte
(86) International application number: PCT/JP2022/007045
(87) International publication number: WO 2022/181566

(57) **Abstract**

A thermal device according to the present disclosure includes a ceramic container, a fluid, and a sealing portion. The container includes an internal space, an opening portion connected to the internal space, and a communication path configured to connect the internal space and the opening portion. The fluid is located in the internal space. The sealing portion blocks the opening portion. The sealing portion includes a core portion and a flange connected to the core portion. The flange is bonded to the container around the opening portion. The core portion is located inside the opening portion. A portion of the core portion is in contact with the wall surface of the opening portion.

## Description

### TECHNICAL FIELD

The present disclosure relates to a thermal device.

### BACKGROUND OF INVENTION

A thermal device using latent heat of a phase transformation substance is known. For example, a vapor chamber, which is a kind of thermal device, releases heat from a heat-generating component by transporting heat from a high-temperature portion to a low-temperature portion using latent heat associated with evaporation and condensation of an actuating fluid sealed inside (see Patent Document 1).

### CITATION LIST

### PATENT LITERATURE

Patent Document 1: JP54-42973 UM-A

### SUMMARY

A thermal device according to one aspect of the present disclosure includes a ceramic container, a fluid, and a sealing portion. The container includes an internal space, an opening portion connected to the internal space, and a communication path configured to connect the internal space and the opening portion. The fluid is located in the internal space. The sealing portion blocks the opening portion. The sealing portion includes a core portion and a flange connected to the core portion. The flange is bonded to the container around the opening portion. The core portion is located inside the opening portion. A portion of the core portion is in contact with the wall surface of the opening portion.

### BRIEF DESCRIPTION OF THE DRAWINGS

FIG. 1 is a perspective view of a heat dissipation device according to an embodiment.
FIG. 2 is a view in which a first member according to an embodiment is viewed from a Z-axis negative direction side toward a Z-axis positive direction.
FIG. 3 is a view in which a second member according to an embodiment is viewed from a Z-axis positive direction side toward a Z-axis negative direction.
FIG. 4 is a view in which an intermediate member according to an embodiment is viewed from the Z-axis positive direction side toward the Z-axis negative direction.
FIG. 5 is a view in which a first groove forming region illustrated in FIG. 2 and a second groove forming region illustrated in FIG. 3 are superimposed on the intermediate member illustrated in FIG. 4.
FIG. 6 is a view illustrating the flow of an actuating fluid in a heat dissipation device according to an embodiment.
FIG. 7 is an explanatory view for explaining the flow of an actuating fluid in the heat dissipation device according to the embodiment.
FIG. 8 is a schematic cross-sectional view illustrating a configuration example of a communication path.
FIG. 9 is a schematic cross-sectional view illustrating the configuration of a sealing portion.
FIG. 10 is a schematic cross-sectional view taken along line X-X illustrated in FIG. 9.
FIG. 11 is a schematic cross-sectional view illustrating a configuration example of an annular body.
FIG. 12 is a schematic cross-sectional view illustrating another configuration example of the annular body.
FIG. 13 is a schematic cross-sectional view illustrating another configuration example of the annular body.
FIG. 14 is a schematic cross-sectional view illustrating another configuration example of the annular body.
FIG. 15 is a schematic cross-sectional view illustrating another configuration example of the annular body.
FIG. 16 is a schematic cross-sectional view illustrating another configuration example of a clump-shaped body.
FIG. 17 is a schematic cross-sectional view illustrating another configuration example of the clump-shaped body.
FIG. 18 is a schematic cross-sectional view illustrating another configuration example of the annular body and the clump-shaped body.
FIG. 19 is a schematic cross-sectional view illustrating another configuration example of a communication path.
FIG. 20 is an explanatory view for explaining an example of a sealing process.
FIG. 21 is an explanatory view for explaining the example of the sealing process.
FIG. 22 is an explanatory view for explaining the example of the sealing process.
FIG. 23 is a schematic cross-sectional view illustrating the configuration of a first variation of the heat dissipation device.
FIG. 24 is a schematic cross-sectional view illustrating the configuration of a second variation of the heat dissipation device.

### DESCRIPTION OF EMBODIMENTS

Modes (hereinafter will be referred to as "embodiments") for implementing a thermal device according to the present disclosure will be described below with reference to the accompanying drawings. The present disclosure is not limited by the embodiments. In addition, embodiments can be appropriately combined so as not to contradict each other in terms of processing content. In the following embodiments, the same portions are denoted by the same reference signs, and overlapping explanations are omitted.

In the embodiments described below, expressions such as "constant", "orthogonal", "perpendicular", and "parallel" may be used, but these expressions do not need to be exactly "constant", "orthogonal", "perpendicular", and "parallel". In other words, each of the above-described expressions allows for deviations in, for example, manufacturing accuracy, positioning accuracy, and the like.

In each of the drawings referred to below, for ease of explanation, an X-axis direction, a Y-axis direction, and a Z-axis direction that are orthogonal to each other may be defined to illustrate a rectangular coordinate system in which the Z-axis positive direction is the vertically upward direction.

In the related art described above, there is room for further improvement in terms of enhancing a sealing characteristic.

A thermal device according to the present disclosure includes a ceramic container, a fluid, and a sealing portion. The container includes an internal space, an opening portion connected to the internal space, and a communication path configured to connect the internal space and the opening portion. The fluid is located in the internal space. The sealing portion blocks the opening portion. The sealing portion has a core portion and a flange connected to the core portion. The flange is bonded to the container around the opening portion. The core portion is located inside the opening portion. A portion of the core portion is in contact with the wall surface of the opening portion. The thermal device having such a configuration has a high sealing characteristic.

The flange may be bonded to the container via a bonding layer made of a metal. The thermal device having such a configuration has an even higher sealing characteristic.

The core portion may have a body portion and a large-diameter portion located over the entire circumference of the body portion and connected to the flange. In this case, the thickness of the large-diameter portion may be thinner than the thickness of the flange. In such a configuration, the large-diameter portion is less subject to elastic deformation than the flange, and the concentration of stress on the large-diameter portion is alleviated. This suppresses the generation of cracks at the opening edge of the communication path.

The tip end of the large-diameter portion may be tapered. This suppresses the generation of cracks at the wall surface of the communication path.

The sealing portion may be separated from the edge of the opening portion. This suppresses the generation of cracks at the opening edge of the communication path.

The sealing portion may have a recessed portion or a protruding portion on an upper surface thereof. For example, when the sealing portion has a recess, it is easy to bring the sealing portion into contact with the heat source. This makes it easier to transfer heat to the interior of the thermal device through the sealing portion, thereby increasing the heat exchange efficiency of the thermal device.

The container may have a main surface and a depression surface depressed with respect to the main surface. In this case, the opening portion may be open to the depression surface, and the flange may be located on the depression surface. Such a configuration can reduce the thickness of the thermal device.

In the embodiment described below, an example in which the sealing portion includes two members: a clump-shaped body and an annular body is described, but the sealing portion does not necessarily need to include a plurality of members and may be composed of one member.

A heat dissipation device, specifically a vapor chamber, which efficiently transfers heat from a high-temperature part to a low-temperature part using the latent heat associated with evaporation and condensation of an actuating fluid (an example of fluid or phase transformation substance) is described as an example of a thermal device according to the present disclosure.

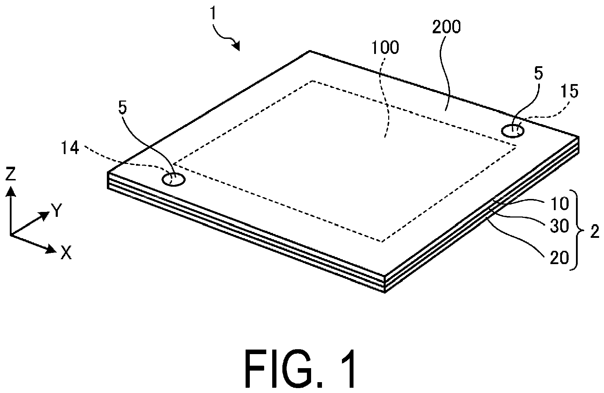

An overall configuration of a heat dissipation device according to an embodiment is described with reference to FIG. 1. FIG. 1 is a perspective view of a heat dissipation device according to an embodiment.

As illustrated in FIG. 1, the heat dissipation device 1 includes a ceramic container 2. The container 2 has a first member 10, a second member 20, and an intermediate member 30. The first member 10, the second member 20, and the intermediate member 30 are all plate-shaped, and are layered such that the intermediate member 30 is sandwiched between the first member 10 and the second member 20.

The container 2 includes an actuating region 100 and a frame region 200. The actuating region 100 has an internal space in which an actuating fluid is sealed as a phase transformation substance. For example, water, a hydrocarbon-based compound, an organic liquid (for example, ethanol, methanol, or the like), or a liquid such as ammonium may be used as the actuating fluid.

The frame region 200 is a region surrounding the actuating region 100. In other words, the frame region 200 is a region outside the actuating region 100 in the heat dissipation device 1. The actuating region 100 is substantially hollow, while the frame region 200 is substantially solid.

The frame region 200 is a region intentionally formed wide in order to suppress, for example, the leakage of the actuating fluid or the vapor of the actuating fluid from the interface between the first member 10 and the intermediate member 30 or between the second member 20 and the intermediate member 30. The frame region 200 is also a region to suppress the entry of the external atmosphere into the internal space of the actuating region 100 through the interface (that is, to ensure the sealing characteristic).

The container 2 has a plurality of (in this case, two) communication paths 14, 15 that connect the internal space of the actuating region 100 with the outside. For example, of the communication paths 14, 15, the communication path 14 is used as an actuating fluid injection hole, while the communication path 15 is used as a gas discharge hole. In this case, in the manufacturing process of the heat dissipation device 1, the actuating fluid is injected into the internal space of the actuating region 100 through the communication path 14 and, accordingly, a gas present in the internal space of the actuating region 100 is discharged externally through the communication path 15. The communication path 14 is located in the vicinity of one of four corners of the first member 10, and the communication path 15 is located in the vicinity of another corner located diagonally opposite the communication path 14.

The heat dissipation device 1 does not necessarily have the plurality of communication paths 14, 15. For example, the heat dissipation device 1 may be configured to include only one of the communication paths 14, 15.

The communication paths 14, 15 are blocked by a sealing portion 5. When the communication paths 14 and 15 are blocked by the sealing portion 5, the internal space of the heat dissipation device 1 is sealed and the actuating fluid is enclosed in the actuating region 100. As described above, the heat dissipation device 1 is a sealed container with a sealed interior.

The actuating fluid fills the internal space of, for example, the actuating region 100, at a ratio of from 10 vol% to 95 vol% with respect to the total volume of the internal space. Preferably, the ratio is from 30 vol% to 75 vol%. More preferably, the ratio is from 40 vol% to 65 vol%. The remaining portion of the internal space of the actuating region 100 other than the portion where the actuating fluid is present is in a vacuum state including some of the vaporized actuating fluid. This maintains vapor-liquid equilibrium in high-temperature environments, making it less prone to dry out, while allowing efficient thermal diffusion in low-temperature environments, thus achieving a high thermal diffusion characteristic in a wide temperature range.

The first member 10, the second member 20, and the intermediate member 30 are made of a ceramic. Examples of the ceramic constituting the first member 10, the second member 20, and the intermediate member 30 that can be used include, for example, alumina (Al₂O₃), zirconia (ZrO₂), silicon carbide (SiC), silicon nitride (Si₃N₄), aluminum nitride (AlN), cordierite (Mg₂Al₃(AlSi₅O₁₈)), and silicon impregnated silicon carbide (SiSiC). The ceramic constituting the first member 10, the second member 20, and the intermediate member 30 may be a single crystal.

A metal heat dissipation device is difficult to make thinner due to the difficulty in obtaining rigidity due to materials and manufacturing methods. Since the metal heat dissipation device includes a metal portion that contacts the actuating fluid, there is room for improvement in corrosion resistance. In contrast, since the heat dissipation device 1 according to the embodiment is composed of the first member 10, the second member 20, and the intermediate member 30 which are all made of a ceramic, it is easier to make the device thinner and more corrosion-resistant than the heat dissipation device made of metal.

In the example illustrated in FIG. 1, the heat dissipation device 1 is placed with the first member 10 facing upward, but the installation state of the heat dissipation device 1 is not limited to the example illustrated in FIG. 1. For example, the heat dissipation device 1 may be placed with the first member 10 facing downward. The heat dissipation device 1 is not limited to the horizontal arrangement as illustrated in FIG. 1, but may be arranged vertically.

Since ceramics are brittle, an important issue for the heat dissipation device including a ceramic container is how to ensure durability against a stress generated associated with, for example, phase transformation of the actuating fluid.

Here, the vapor chamber described in Patent Document 1 includes a communication path for injecting the actuating fluid in the actuating region. In the actuating region, the thickness of the ceramic is reduced by an amount corresponding to the internal space. Therefore, the chamber described in Patent Document 1 with the communication path provided in the actuating region easily lacks durability against stress and has a risk of generation of cracks or the like in the container. When the container is cracked, a dryout of the actuating fluid enclosed in the internal space may occur to deteriorate the heat dissipation efficiency.

In contrast, the heat dissipation device 1 according to the embodiment includes the communication paths 14, 15 located in the frame region 200. Unlike the actuating region 100, the frame region 200 is solid. The communication paths 14, 15 located in the frame region 200 can increase durability compared to the case in which the communication paths 14, 15 are located in the actuating region 100. Thus, the heat dissipation device 1 according to the embodiment can enhance durability.

The heat dissipation device 1 according to the embodiment can also enhance the heat dissipation characteristic, because the actuating region 100 can have a wider effective space than the case in which the communication paths 14, 15 are located in the actuating region 100.

The frame region 200 where the communication paths 14, 15 are located is made of the ceramic material same as or similar to that of the actuating region 100, making it less likely to generate stress due to a difference in thermal expansion. Thus, the heat dissipation device 1 according to the embodiment has a high reliability.

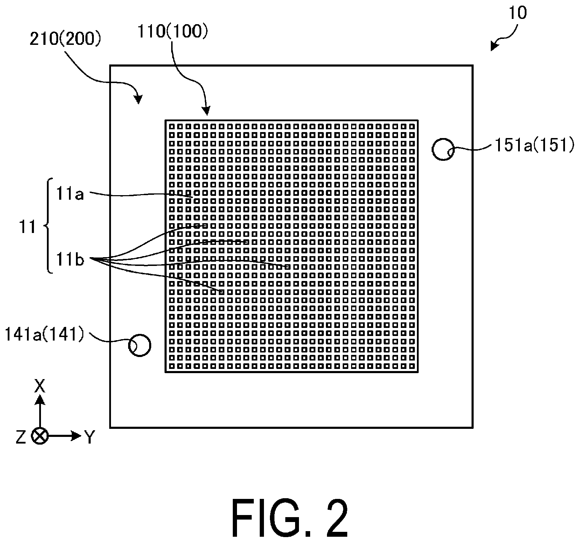

The configuration of the first member 10 will be described with reference to FIG. 2. FIG. 2 is a view in which a first member 10 according to an embodiment is viewed from the Z-axis negative direction side toward the Z-axis positive direction.

FIG. 2 illustrates a lower surface of the first member 10, specifically, a surface (third surface) facing the upper surface (first surface) of the intermediate member 30. As illustrated in FIG. 2, the first member 10 includes a first groove portion 11 having a lattice shape on the third surface.

The first groove portion 11 includes a first recessed portion 11a recessed with respect to the third surface and a plurality of first protruding portions 11b located within the first recessed portion 11a. The first recessed portion 11a is located at the center portion of the third surface, and its contour in plan view is, for example, a square. The plurality of first protruding portions 11b is arranged longitudinally and laterally at intervals from each other within the first recessed portion 11a. The first recessed portion 11a and the plurality of first protruding portions 11b make the first groove portion 11 have a lattice shape.

Hereinafter, a region where the first groove portion 11 is located on the third surface of the first member 10, will be referred to as a "first groove forming region 110". The first groove forming region 110 constitutes a part of the actuating region 100. The first member 10 also includes a first frame region 210 having a rectangular frame shape surrounding the first groove forming region 110. The first frame region 210 constitutes a part of the frame region 200.

The first frame region 210 has a plurality of (here, two) through holes 141a, 151a extending through the first member 10 in the thickness direction (here, the Z-axis direction). The through hole 141a constitutes a part of a first portion 141 of the communication path 14, and the through hole 151a constitutes a part of a first portion 151 of the communication path 15.

A heat source is disposed at the center portion of the upper surface (fifth surface) located opposite to the lower surface (third surface) of the first member 10.

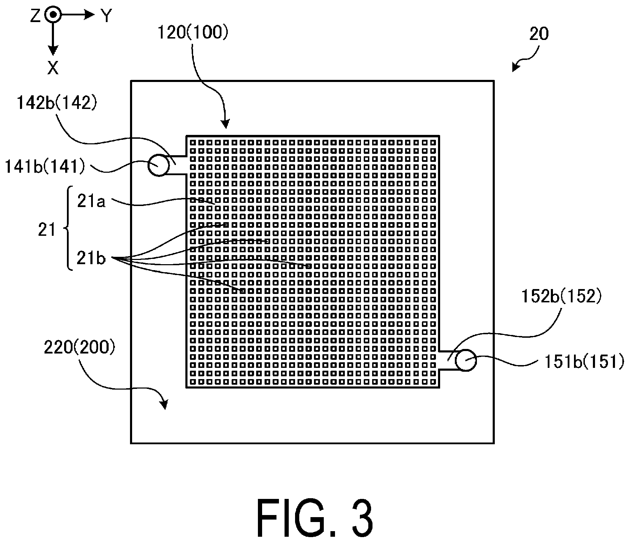

The configuration of the second member 20 will be described with reference to FIG. 3. FIG. 3 is a view in which the second member 20 according to the embodiment is viewed from the Z-axis positive direction side toward the Z-axis negative direction.

FIG. 3 illustrates the upper surface of the second member 20, specifically, the surface (the fourth surface) facing the lower surface (the second surface) of the intermediate member 30. As illustrated in FIG. 3, the second member 20 includes a second groove portion 21 having a lattice shape on the fourth surface.

The second groove portion 21 includes a second recessed portion 21a recessed with respect to the fourth surface and a plurality of second protruding portions 21b located within the second recessed portion 21a. The second recessed portion 21a is located at the center portion of the fourth surface, and its contour in plan view is, for example, a square. The plurality of second protruding portions 21b is arranged longitudinally and laterally at intervals from each other within the second recessed portion 21a. The second recessed portion 21a and the plurality of second protruding portions 21b make the second groove portion 21 have a lattice shape.

Hereinafter, a region where the second groove portion 21 is located on the fourth surface of the second member 20 will be referred to as a "second groove forming region 120". The second groove forming region 120 constitutes a part of the actuating region 100. The second member 20 includes a second frame region 220 having a rectangular frame shape surrounding the second groove forming region 120. The second frame region 220 constitutes a part of the frame region 200.

The size of the second groove forming region 120 in the second member 20 is the same as the size of the first groove forming region 110 in the first member 10. The position of the second groove forming region 120 on the fourth surface of the second member 20 is the same as the position of the first groove forming region 110 on the third surface of the first member 10.

Thus, by forming the first and second groove portions 11, 21 having a lattice shape, the actuating fluid can be efficiently circulated in the internal space of the heat dissipation device 1. Note that each of the first groove portion 11 and the second groove portion 21 need not necessarily have a lattice shape.

Located in the second frame region 220 are a plurality of (here, two) recessed portions 141b, 151b recessed with respect to the upper surface (fourth surface) of the second member 20. The recessed portion 141b constitutes a part of the first portion 141 in the communication path 14, and the recessed portion 151b constitutes a part of the first portion 151 in the communication path 15.

The second frame region 220 also includes grooves 142b, 152b. The groove 142b is a path extending in a second direction (here, the Y-axis direction) intersecting the extending direction (which is the first direction, and here, the Z-axis direction) of the first portion 141 in the communication path 14. One end of the groove 142b is open to the recessed portion 141b at the first portion 141, and the other end is open to the second groove forming region 120. The groove 152b is a path extending in a second direction (here, the Y-axis direction) intersecting the extending direction (which is the first direction, and here, the Z-axis direction) of the first portion 151 in the communication path 15. One end of the groove 142b is open to the recessed portion 151b at the first portion 151, and the other end is open to the second groove forming region 120.

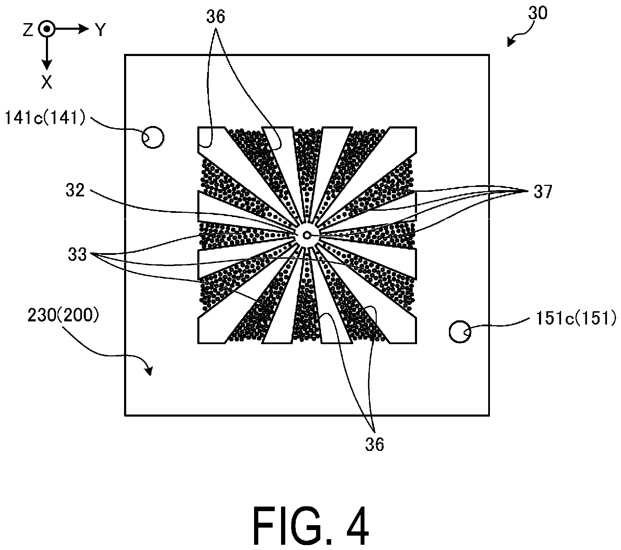

The configuration of the intermediate member 30 will be described with reference to FIG. 4. FIG. 4 is a view in which an intermediate member 30 according to the embodiment is viewed from the Z-axis positive direction side toward the Z-axis negative direction.

As illustrated in FIG. 4, the intermediate member 30 has a third frame region 230 having a rectangular frame shape. The third frame region 230 constitutes a part of the frame region 200. The intermediate member 30 includes a circular center portion 32 in a plan view located inside the third frame region 230 and a plurality of connections 33 located between the center portion 32 and the third frame region 230 and connecting the center portion 32 and the third frame region 230. In the example illustrated in FIG. 4, the center portion 32 is located at the center of intermediate member 30. The plurality of connections 33 is spaced apart from each other and extends radially while widening from the center portion 32 toward the third frame region 230.

The intermediate member 30 also includes a plurality of vapor holes 36 and a plurality of reflux holes 37. Each of the plurality of vapor holes 36 and each of the plurality of reflux holes 37 extend through the upper surface (first surface) and the lower surface (second surface) of the intermediate member 30.

The plurality of vapor holes 36 function as a part of a path for the vapor of the actuating fluid. Each of the plurality of vapor holes 36 is located between two adjacent connections 33. That is, the plurality of vapor holes 36 and the plurality of connections 33 are alternately located in the circumferential direction. Similar to the plurality of connections 33, the plurality of vapor holes 36 is spaced apart from each other and extends radially while widening from the center portion 32 toward the third frame region 230.

The plurality of reflux holes 37 function as a part of a path for the actuating fluid. The reflux holes 37 are micropores, each having an opening area smaller than the vapor holes 36 described above. Specifically, the reflux holes 37 are small enough to allow capillary phenomenon to occur in the actuating fluid passing through the reflux holes 37.

In the third frame region 230, a plurality (here, two) of through holes 141c, 151c are located extending through the intermediate member 30 in the thickness direction (here, in the Z-axis direction). The through hole 141c constitutes a part of the first portion 141 of the communication path 14, and the through hole 151c constitutes a part of the first portion 151 of the communication path 15.

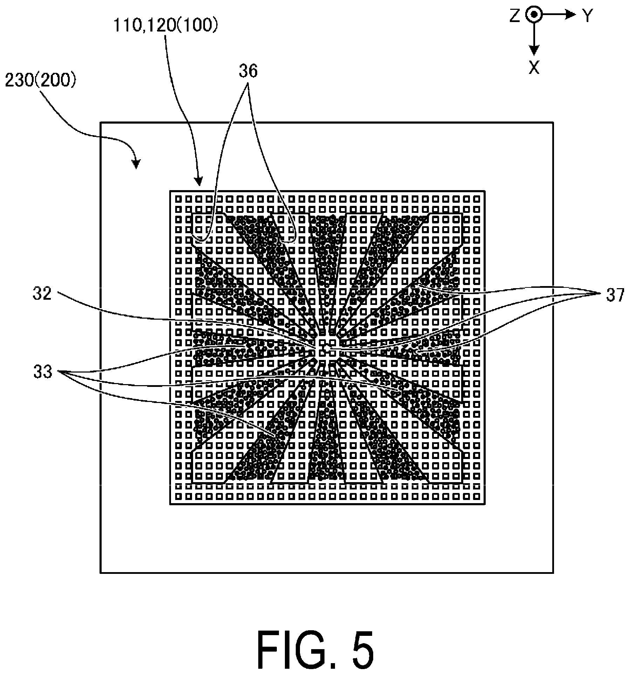

FIG. 5 is a view in which the first groove forming region 110 illustrated in FIG. 2 and the second groove forming region 120 illustrated in FIG. 3 are superimposed on the intermediate member 30 illustrated in FIG. 4. In FIG. 5, the communication paths 14, 15 are omitted for ease of understanding.

As illustrated in FIG. 5, the first and second groove forming regions 110, 120 overlap the third frame region 230 of the intermediate member 30. That is, the first and second groove forming regions 110, 120 spread outward from a region (hereinafter referred to as a "hole forming region") where the plurality of vapor holes 36 and the plurality of reflux holes 37 are formed in the intermediate member 30.

Thus, by making the first groove forming region 110 of the first member 10 and the second groove forming region 120 of the second member 20 wider than the hole forming region of the intermediate member 30, the internal space of the heat dissipation device 1 can be expanded outward compared to a case in which the first and second groove forming regions 110, 120 have the size same as or similar to the size of the hole forming region.

The heat source is disposed at the center portion of the heat dissipation device 1. The temperature of the heat dissipation device 1 becomes lower as it is away from the heat source, that is, as it becomes closer to the outer peripheral portion of the heat dissipation device 1. The vapor of the actuating fluid condenses into a liquid upon moving to a low-temperature region. By spreading the internal space of the heat dissipation device 1 outward, condensation of the actuating fluid is more likely to occur. This makes it difficult for dryout to occur.

Here, an example in which the first groove forming region 110 and the second groove forming region 120 spread outward from the hole forming region of the intermediate member 30 is illustrated; however, the configuration is not limited to this, the hole forming region of the intermediate member 30 may spread outward from the first groove forming region 110 and the second groove forming region 120.

The actuating region 100 of the heat dissipation device 1 has an internal space sandwiched between the first groove forming region 110 and the second groove forming region 120, and an actuating fluid is enclosed in the internal space. In addition, the intermediate member 30 is interposed between the first and second groove forming regions 110, 120 in the internal space, so that the actuating region 100 is partitioned into a first space sandwiched between the first groove forming region 110 and the intermediate member 30 and a second space sandwiched between the second groove forming region 120 and the intermediate member 30. The first space and the second space are connected via the vapor holes 36 and the reflux holes 37 formed in the intermediate member 30.

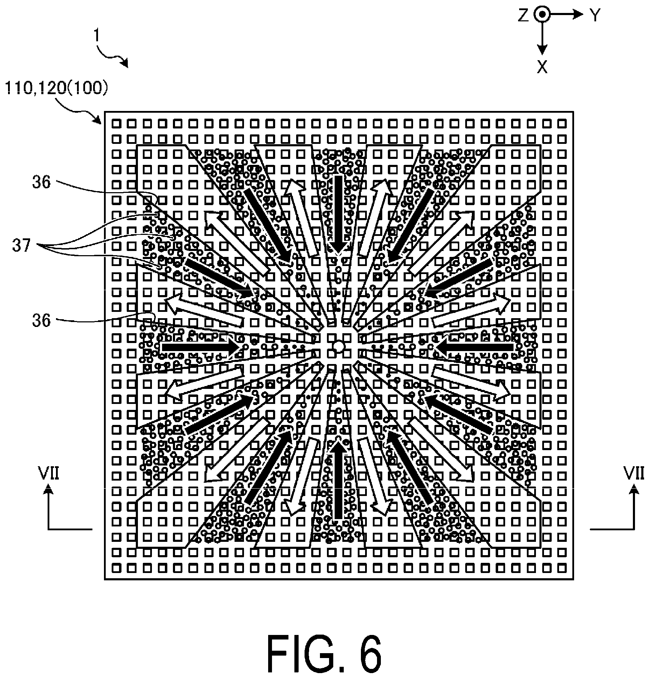

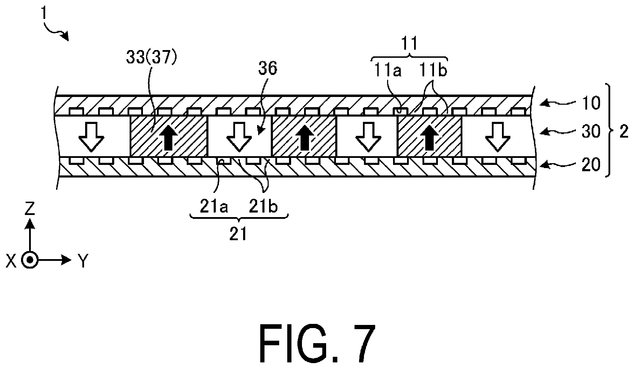

The flow of the actuating fluid in the heat dissipation device 1 according to the embodiment is described with reference to FIGs. 6 and 7. FIGs. 6 and 7 illustrate the flow of the actuating fluid in the heat dissipation device 1 according to the embodiment. FIG. 6 is a view in which the third frame region 230 is omitted from the view illustrated in FIG. 5, and FIG. 7 is a cross-sectional view taken along arrow VII-VII in FIG. 6. In FIGs. 6 and 7, the vapor flow is indicated by white arrows, and the liquid flow is indicated by black arrows.

The actuating fluid is vaporized into a vapor by being heated by a heat source. As described above, the heat source is disposed at the center portion of the upper surface (fifth surface) of the first member 10 (see FIGs. 1 and 2). Thus, the vapor of the actuating fluid is generated at the center portion of the first space (the space sandwiched between the first member 10 and the intermediate member 30).

The vapor of the actuating fluid diffuses in the in-plane direction (XY plane direction) of the heat dissipation device 1 through the first groove portion 11 of the first groove forming region 110 (see white arrows in FIG. 6), while moving through the plurality of vapor holes 36 to the second space (space sandwiched between the second member 20 and intermediate member 30) (see white arrows in FIG. 7).

The vapor that has moved to the second space condenses into a liquid as the temperature decreases. The liquefied actuating fluid moves through the second groove forming region 120 toward the center portion of the heat dissipation device 1 due to the capillary action of the second groove portion 21 (see black arrows in FIG. 6). In this process, the actuating fluid enters the reflux holes 37 and is returned to the first space by the capillary action of the reflux holes 37 (see the black arrows in FIG. 7). By repeating the above cycle, the heat dissipation device 1 can transfer heat from the heat source.

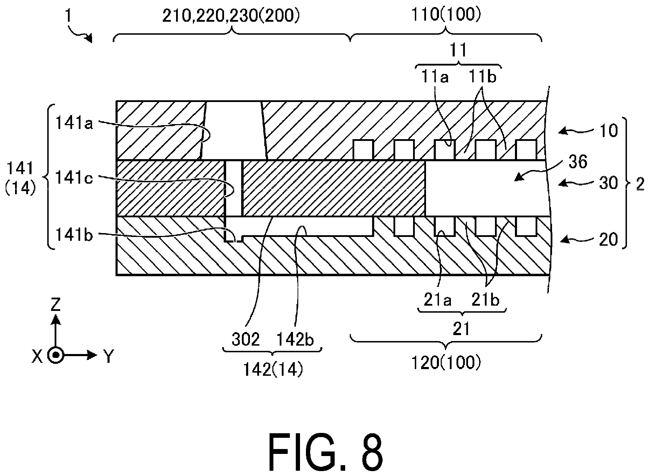

The configuration of the communication paths 14, 15 is described with reference to FIG. 8. FIG. 8 is a schematic cross-sectional view illustrating a configuration example of the communication path 14. Although the communication path 14 is illustrated in FIG. 8 as an example, the communication path 15 has the same configuration as the communication path 14.

As illustrated in FIG. 8, the communication path 14 connects the internal space of the actuating region 100 with the outside. The communication path 14 includes a first portion 141 extending in the thickness direction (here, the Z-axis direction) of the container 2 and opening to the outside, and a second portion 142 extending in the surface direction (here, the Y-axis direction) of the container 2 and opening to the internal space of the actuating region 100.

The first portion 141 is composed of a through hole 141a of the first member 10, a recessed portion 141b of the second member 20, and a through hole 141c of the intermediate member 30. The second portion 142 is composed of a groove 142b of the second member 20 and a lower surface 302 (second surface) of the intermediate member 30. FIG. 8 illustrates an example in which the recessed portion 141b of the communication path 14 is recessed deeper than the groove 142b of the second portion 142, but the recessed portion 141b and the groove 142b may be flush with each other.

Thus, the communication path 14 includes the first portion 141 extending in the first direction (here, the Z-axis direction) and the second portion 142 extending in the direction (here, the Y-axis direction) intersecting the first direction. In other words, the communication path 14 is bent. Therefore, according to the heat dissipation device 1 of the embodiment, even when a high pressure is generated in the actuating region 100, the high pressure is unlikely to be applied to the sealing portion 5, thus increasing the reliability.

The first portion 141 is open to the upper surface of the first member 10 and extends through the first and second spaces of the actuating region 100 in the frame region 200. The second portion 142 is located in the frame region 200 on the second space side of the actuating region 100.

In the heat dissipation device 1, the first space side of the first space and the second space is under high pressure. In other words, the first space and the second space, the second space side has a relatively low pressure. The second portion 142 located on the second space side can suppress application of a high pressure to the communication path 14.

As illustrated in FIG. 1, the communication path 14 is located so as to sandwich the actuating region 100 between the communication path 14 and the communication path 15. By arranging the two communication paths 14, 15 in this manner, a localized drop of durability can be suppressed, as compared to a case, for example, in which the two communication paths 14, 15 are arranged side by side.

In the first portion 141 of the communication path 14, the through hole 141a has a first opening which corresponds to the first path 141a that opens to the outside. The through hole 141c is continuous with the through hole 141a, and corresponds to the second path 141c having a smaller diameter than the first path.

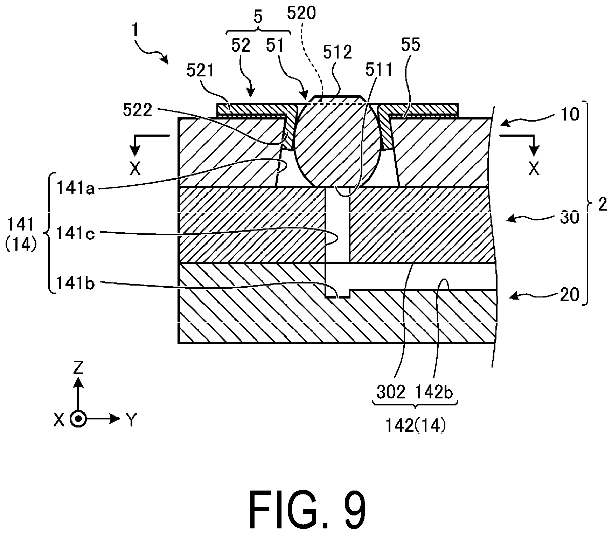

The configuration of the sealing portion 5 is described. FIG. 9 is a schematic cross-sectional view illustrating a configuration of the sealing portion 5.

As illustrated in FIG. 9, the sealing portion 5 includes a clump-shaped body 51 and an annular body 52. The clump-shaped body 51 and the annular body 52 constitute a core portion and a flange of the sealing portion 5, respectively. For example, the clump-shaped body 51 and the annular body 52 are made of a metal. Examples of the metal constituting the clump-shaped body 51 and the annular body 52 include Cu (copper), for example. The clump-shaped body 51 and the annular body 52 may be made of a metal other than Cu. Examples of the metal other than Cu include Al, Cr, Ni, Co, Sn, Au, Fe, and Co. The metal constituting the clump-shaped body 51 and the annular body 52 may be an alloy, such as stainless steel, containing at least two of Cu, Al, Cr, Ni, Co, Sn, Au, Fe, and Co. The metal constituting the clump-shaped body 51 and the annular body 52 is preferably a metal containing Cu as a main component. The main component accounts for, for example, 50 mass% or more or 80 mass% or more of the material.

The clump-shaped body 51 is a clump-shaped member. For example, the clump-shaped body 51 is substantially spherical. In the embodiment, the clump-shaped body 51 has flat surfaces 511, 512, each at a first end portion (here, an upper end portion of the clump-shaped body 51) and a second end portion (here, a lower end portion of the clump-shaped body 51) in the thickness direction, respectively, of the first member 10. The flat surfaces 511, 512 are parallel to each other. In a cross-sectional view in which the clump-shaped body 51 is cut along a cross section perpendicular to the flat surfaces 511, 512 (that is, the cross-sectional view illustrated in FIG. 9), the flat surfaces 511, 512 are connected via a convex curved surface. As described above, the clump-shaped body 51 according to the embodiment is a spherical body having the flat surfaces 511, 512 at the first and second end portions, respectively.

The annular body 52 has an opening 520 (an example of a second opening) which is smaller in diameter (diameter on the upper surface of the first member 10) than the opening diameter of the outer side opening (an example of a first opening) of the through hole 141a, and is located on the first member 10 so that the opening 520 and the first opening of the through hole 141a overlap.

The annular body 52 has a first portion 521 located on the upper surface of the first member 10 and a second portion 522 located on the wall surface of the through hole 141a. The first portion 521 is a thin plate-shaped portion extending along the upper surface of the first member 10. The first portion 521 is bonded to the upper surface of the first member 10 via a bonding layer 55 made of, for example, a bonding material such as a brazing material.

The first portion 521 has a substantially ring shape in a plan view, and the opening 520 is located at the center portion thereof. The second portion 522 is a portion extending downward from the edge of the opening 520 toward a deep portion of the through hole 141a. The deep portion of the through hole 141a may be a place in the through hole 141a deeper than the edge of the opening 520, and is not limited to a specific (one) portion. The second portion 522 extends along the wall surface of the through hole 141a. The second portion 522 does not necessarily extend along the wall surface of the through hole 141a. The second portion 522 is not necessarily in contact with the wall surface of the through hole 141a, and a gap may by formed between the second portion 522 and the wall surface of the through hole 141a.

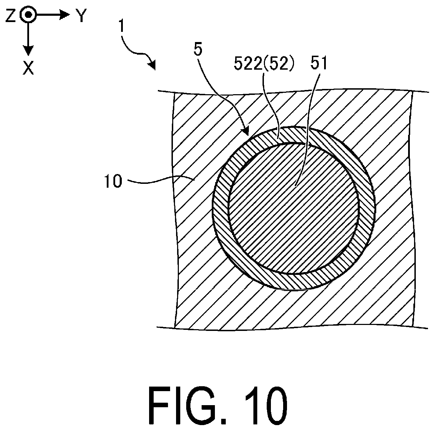

FIG. 10 is a schematic cross-sectional view taken along line X-X in FIG. 9. As illustrated in FIG. 10, the second portion 522 of the annular body 52 is located between the first member 10 and the clump-shaped body 51. The clump-shaped body 51 is located inward of the second portion 522 in the radial direction of the through hole 141a, and is in contact with the second portion 522 over the entire circumference. The clump-shaped body 51 is physically integrated with the annular body 52 at portions in contact with the second portion 522. Here, " physically integrated " means that the clump-shaped body 51 and the annular body 52 are physically bonded to each other without a gap. The term " physically integrated " also means that the ratio of diffusion bonding is zero or small.

The clump-shaped body 51 presses the second portion 522 toward the wall surface of the through hole 141a. In other words, the clump-shaped body 51 presses the through hole 141a via the second portion 522. As described above, the second portion 522 is not necessarily in contact with the wall surface of the through hole 141a. Even in this case, the first portion 521 and the upper surface of the first member 10 are bonded to each other with the bonding material, so that the sealing characteristic of the heat dissipation device 1 is not impaired.

The sealing portion 5 according to the embodiment seals the heat dissipation device 1 by blocking the through hole 141a with the clump-shaped body 51 and the annular body 52. With such a configuration, the through hole 141a can be blocked while suppressing the generation of cracks in the first member 10, compared to the case in which the through hole 141a is blocked using only the clump-shaped body 51, that is, when sealing is performed between metals and ceramics.

The sealing portion 5 according to the embodiment blocks the through hole 141a with the clump-shaped body 51 and the second portion 522 of the annular body 52 located inside the through hole 141a. Such a configuration allows the clump-shaped body 51 and the second portion 522 to press against each other, thus enhancing the sealing characteristic of the heat dissipation device 1.

In the sealing portion 5 according to the embodiment, the clump-shaped body 51 enters the through hole 141a. Such a configuration can suppress, for example, adhesion of the actuating fluid to the wall surface of the through hole 141a.

In the heat dissipation device 1 according to the embodiment, the through hole 141c serving as the second path is located below the clump-shaped body 51. That is, in the plan view of the heat dissipation device 1, the through hole 141c is provided at a position overlapping the clump-shaped body 51. In the sealing portion 5 according to the embodiment, the clump-shaped body 51 blocks the through hole 141c. Specifically, the clump-shaped body 51 has the flat surface 511, and the flat surface 511 blocks the opening portion of the through hole 141c. Such a configuration can more reliably suppress the entry of the actuating fluid into the communication path 14 (through hole 141a). Also, further enhancement of the sealing characteristic of the heat dissipation device 1 can be achieved.

Although not illustrated here, the upper surface (first surface) of the intermediate member 30 may have a plurality of irregularities at positions facing the flat surface 511 of the clump-shaped body 51. In such a case, misalignment of the clump-shaped body 51 in the horizontal direction (orthogonal to the thickness direction of the heat dissipation device 1) can be suppressed.

In the heat dissipation device 1 according to the embodiment, the through hole 141c is provided in the intermediate member 30 made of a ceramic. Such a configuration can further suppress the cracks of the intermediate member 30, even when the clump-shaped body 51 contacts the intermediate member 30 in press-fitting the clump-shaped body 51 into the communication path 14, compared to the case in which no through hole 141c is provided at the contact point.

The heat dissipation device 1 according to the embodiment is a sealed ceramic container. That is, the first member 10, the second member 20, and the intermediate member 30 are made of ceramics.

Ceramics generally have a larger Young's modulus than metals, that is, have higher rigidity. The clump-shaped body 51 made of a metal (a metal clump-shaped body) of the sealing portion 5 is thermally deformed in a direction of expanding the communication path 14 (the through hole 141a). When the heat dissipation device is made of the metal and the clump-shaped body 51 is deformed in the direction of expanding the communication path 14, the through hole 141a tends to be deformed easily in the direction of expanding the diameter along with the deformation. In the ceramic heat dissipation device 1, the through hole 141a is less likely to be deformed compared to the metal heat dissipation device, even when the clump-shaped body 51 is deformed in the direction of expanding the through hole 141a. When compared to the metal heat dissipation device, the ceramic heat dissipation device 1 can easily ensure the sealing characteristic against a temperature change (particularly, a temperature rise).

In another aspect, ceramics have a lower thermal expansion coefficient than the majority of metals, except for some metals such as W (tungsten), Mo (molybdenum), Ti (titanium), Nb (niobium), Zr (zirconium), and the like. That is, the ceramic heat dissipation device 1 is less likely to be thermally deformed than the metal heat dissipation device. For this reason, the ceramic heat dissipation device 1 is more likely to maintain a state in which the clump-shaped body 51 presses the through hole 141a through the annular body 52 than the metal heat dissipation device. The ceramic heat dissipation device 1 can more easily ensure the sealing characteristic with respect to the thermal cycling compared to the metal heat dissipation device. The ceramic heat dissipation device 1 is less susceptible to corrosion when exposed to acid or high-temperature steam, and less susceptible to oxidation at high temperatures, compared to the metal heat dissipation device.

Examples of the ceramic constituting the first member 10, the second member 20, and the intermediate member 30 include alumina, zirconia, and silicon carbide, as described above. Among these ceramics, alumina is preferably used as the ceramic constituting the first member 10, the second member 20, and the intermediate member 30, as it is inexpensive, causes only little harm to the environment, and is easy to process.

The interior of the heat dissipation device 1 of the embodiment is in a reduced pressure state (including vacuum) when no heat source is disposed on the upper surface (fifth surface) of the first member 10. When the heat source is disposed on the upper surface of the first member 10, the interior of the heat dissipation device 1 is in a pressurized state as the actuating fluid vaporizes and expands in volume. Thus, the pressure state inside the heat dissipation device 1 alternates between the reduced pressure state and the pressurized state depending on the presence or absence of the heat source.

On the other hand, the sealing portion 5 of the embodiment presses the annular body 52 toward the wall surface of the communication path 14 by the clump-shaped body 51, making it easy to ensure the sealing characteristic in both the reduced pressure state and the pressurized state.

As illustrated in FIGs. 8 and 9, the through hole 141a of the communication path 14 is tapered to expand the diameter from the upper surface of the first member 10 to the lower surface (third surface). This configuration makes it more difficult for the clump-shaped body 51 to come off from the communication path 14 even when the interior of the heat dissipation device 1 is in a pressurized state, thus ensuring a reliable sealing characteristic in the pressurized state.

Alternatively, the through hole 141a of the communication path 14 may be tapered with a reduced diameter from the upper surface of the first member 10 toward the lower surface (third surface). In that case, the stress applied to the through hole 141a can be distributed in the thickness direction of the first member 10 when the clump-shaped body 51 is press-fitted into the through hole 141a, making it less likely to generate cracks in the through hole 141a during press-fitting of the clump-shaped body 51.

In the sealing portion 5 according to the embodiment, the annular body 52 has the first portion 521, and the first portion 521 is bonded to the upper surface of the first member 10 around the through hole 141a. Such a configuration can suppress the generation and propagation of cracks around the through hole 141a.

In the sealing portion 5 according to the embodiment, the diameter of the opening 520 of the annular body 52 is smaller than the diameter of the through hole 141a. In other words, the first portion 521 of the annular body 52 extends further inward in the radial direction of the through hole 141a than the opening edge of the through hole 141a (that is, the edge of the first opening). Such a configuration can suppress the generation and propagation of cracks around the through hole 141a, especially from the opening edge of the through hole 141a.

In the sealing portion 5 according to the embodiment, the annular body 52 is bonded to the upper surface of the first member 10 via a bonding layer 55. Such a configuration can enhance the sealing characteristic between the upper surface of the first member 10 and the sealing portion 5.

In the sealing portion 5 according to the embodiment, when comparing the clump-shaped body 51 and the annular body 52, the clump-shaped body 51 protrudes more (higher) from the upper surface of the first member 10 (protrusion height) than the annular body 52. That is, the clump-shaped body 51 protrudes from the upper surface of the first member 10 more than the annular body 52. Such a configuration makes it easier to bring the clump-shaped body 51 into contact with the heat source when the heat source is disposed on the upper surface of the clump-shaped body 51. By bringing the clump-shaped body 51 made of metal into contact with the heat source, heat can easily be transferred to the interior of the heat dissipation device 1 through the clump-shaped body 51, thus increasing the heat exchange efficiency of the heat dissipation device 1.

In the heat dissipation device 1 of the embodiment, the stress on the container 2 preferably does not exceed a fracture strength of the container 2. Of the residual stresses exerted on the container 2 by the clump-shaped body 51, the residual stress in the region not in contact with the annular body 52 is preferably greater than the residual stress in the region in contact with the annular body 52.

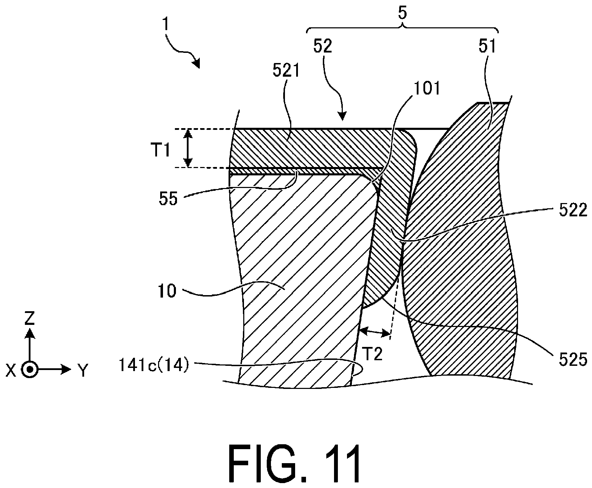

FIG. 11 is a schematic cross-sectional view illustrating a configuration example of the annular body 52. As illustrated in FIG. 11, of the annular body 52, a thickness T2 of the second portion 522 may be thinner than a thickness T 1 of the first portion 521. The clump-shaped body 51 applies stress in a direction of pressing the annular body 52. This stress is concentrated on the opening edge 101 of the communication path 14, which may generate cracks in the opening edge 101 of the communication path 14. When the thickness T2 of the second portion 522 is thinner than the thickness T1 of the first portion 521, the amount of elastic deformation of the second portion 522 is relatively less, reducing the concentration of stress and suppressing generation of cracks at the opening edge 101 of the communication path 14.

The opening edge 101 of the communication path 14 may be separated from the annular body 52. For example, as illustrated in FIG. 11, the opening edge 101 of the communication path 14 may be chamfered in an R-shape in a cross-sectional view. In other words, the opening edge 101 may be curved in a convex shape in a cross-sectional view. Accordingly, a gap can be formed between the opening edge 101 of the communication path 14 and the corner portion of the annular body 52. That is, the opening edge 101 of the communication path 14 can be separated from the annular body 52.

By separating the opening edge 101 of the communication path 14 from the annular body 52 in this manner, the stress caused by the thermal expansion difference between the first member 10 and the annular body 52 is less likely to be transferred to the opening edge 101 of the communication path 14, making it less likely to generate cracks in the opening edge 101 of the communication path 14.

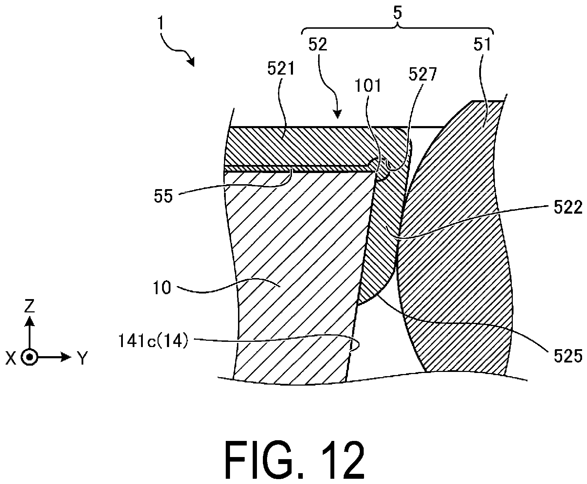

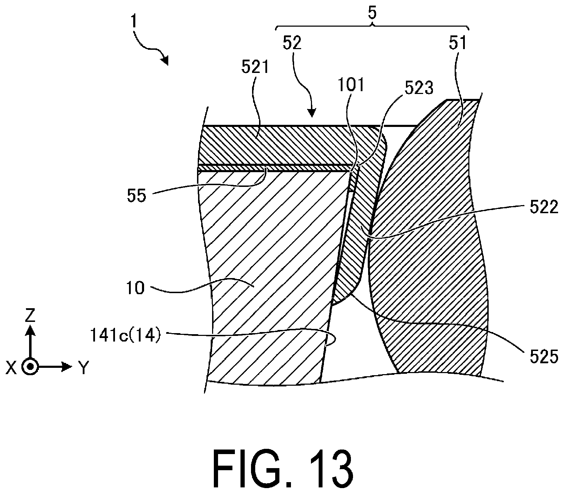

FIGs. 12 and 13 are schematic cross-sectional views illustrating other examples of the annular body 52. As illustrated in FIG. 12, the annular body 52 may have a recessed portion 527 at the corner between the first portion 521 and the second portion 522 facing the opening edge 101 of the communication path 14. The recessed portion 527 extends circumferentially and is recessed away from the opening edge 101 of the communication path 14. Even in such a case, the opening edge 101 of the communication path 14 can be separated from the annular body 52. As illustrated in FIG. 13, the annular body 52 may have a corner portion 523 between the first portion 521 and the second portion 522 facing the opening edge 101 of the communication path 14, and the corner portion 523 may be located radially inward of the opening edge 101 of the communication path 14. Even in such a case, the opening edge 101 of the communication path 14 can be separated from the annular body 52.

As illustrated in FIG. 11, a tip end 525 of the second portion 522 may be tapered. In other words, the tip end 525 of the second portion 522 may be shaped to become thinner toward the tip end. The tapered tip end 525 of the second portion 522 can alleviate the concentration of stress by the clump-shaped body 51 to expand the wall surface of the through hole 141a, thus suppressing the generation of cracks in the wall surface of the through hole 141a.

As illustrated in FIG. 11, the tip of the tip end 525 of the second portion 522 may be closer to the wall surface side of the through hole 141a. When the second portion 522 of the annular body 52 contacts the through hole 141a, and the tip end of the second portion 522 is closer to the wall surface side of the through hole 141a, the contact area between the second portion 522 and the wall surface of the through hole 141a is large, making the heat dissipation device 1 have a higher sealing characteristic.

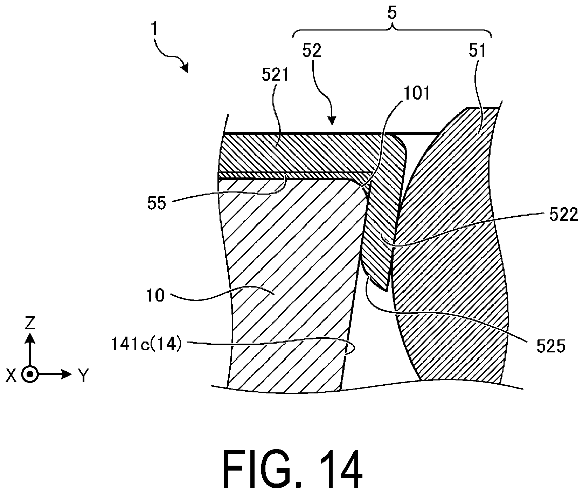

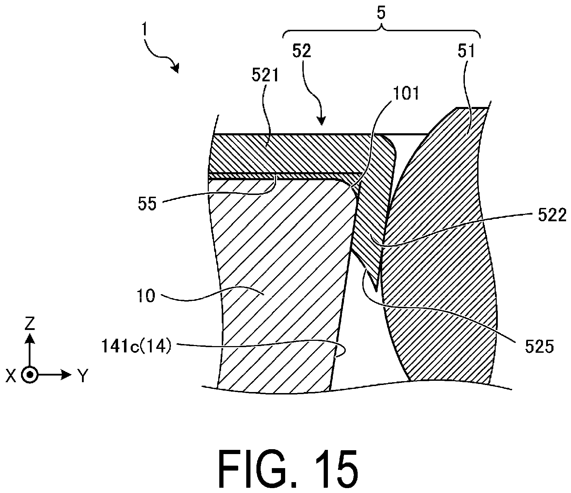

FIGs. 14 and 15 are schematic cross-sectional views illustrating other configuration examples of the annular body 52. As illustrated in FIGs. 14 and 15, the tip of the tip end 525 of the second portion 522 may be closer to the clump-shaped body 51 side. In this case, the heat dissipation device 1 has a higher sealing characteristic because of the large contact area between the second portion 522 and the clump-shaped body 51. The tip end 525 of the second portion 522 may be convexly curved in a cross-sectional view as illustrated in FIGs. 11 to 14, or concavely curved in a cross-sectional view as illustrated in FIG. 15.

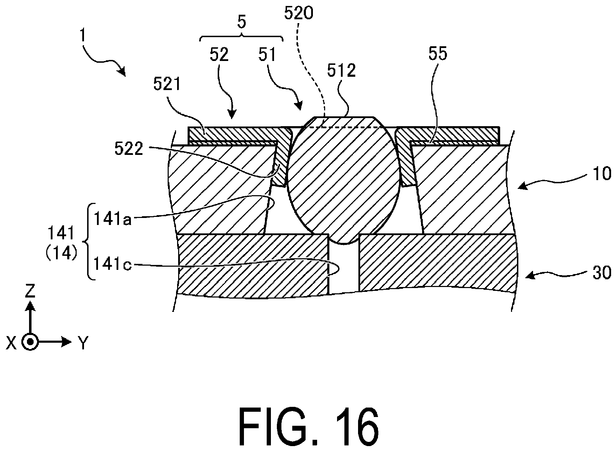

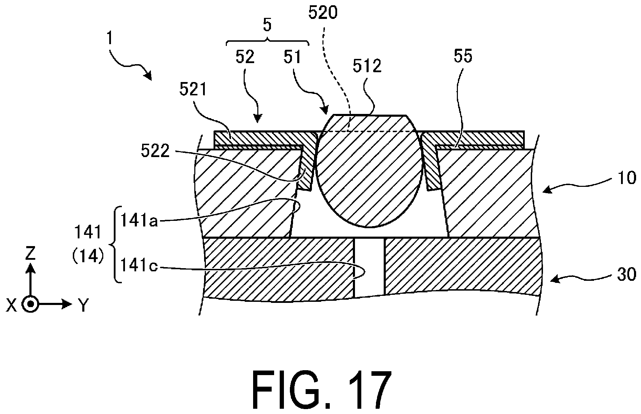

FIGs. 16 and 17 are schematic cross-sectional views illustrating other configuration examples of the clump-shaped body 51. As illustrated in FIG. 16, the second end portion (here, the lower end portion of the clump-shaped body 51) of the clump-shaped body 51 may enter the through hole 141c. Such a configuration can more reliably suppress the entry of the actuating fluid into the through hole 141a. Also, further enhancement of the sealing characteristic of the heat dissipation device 1 can be achieved. As illustrated in FIG. 17, the clump-shaped body 51 may be separated from the upper surface (first surface) of the intermediate member 30. In this case, the clump-shaped body 51 may have the flat surface 512 only at the first end portion of the first end portion (here, the upper end portion of the clump-shaped body 51) and the second end portion (here, the lower end portion of the clump-shaped body 51).

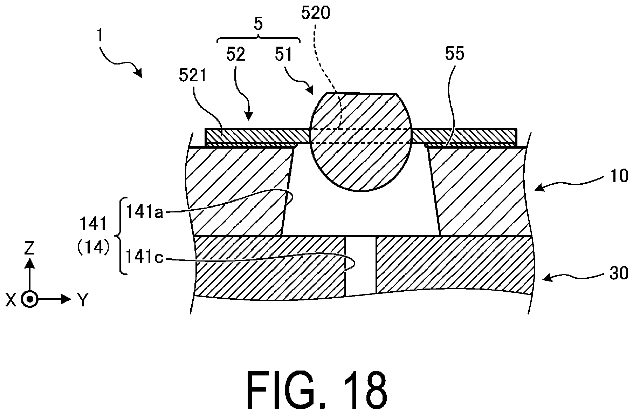

FIG. 18 is a schematic cross-sectional view illustrating another configuration example of the clump-shaped body 51 and the annular body 52. As illustrated in FIG. 18, the annular body 52 may be composed of only the first portion 521. In this case, the clump-shaped body 51 is in contact with the wall surface of the opening 520 of the annular body 52, thus physically integrated with the annular body 52 at the contact portion. Such a configuration can more reliably suppress the generation or propagation of cracks around the communication path 14, especially from the opening edge 101 of the communication path 14. Thus, the annular body 52 does not necessarily have the second portion 522.

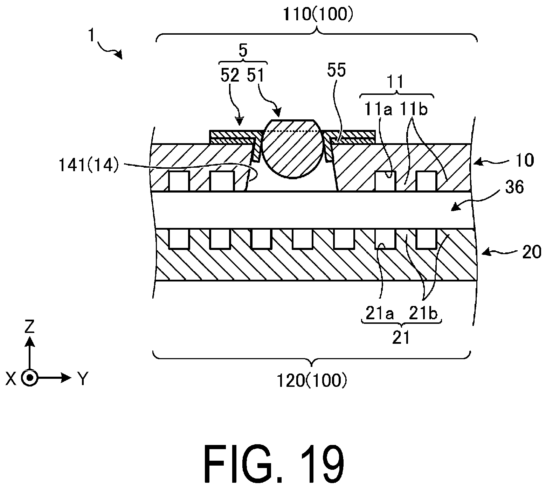

FIG. 19 is a schematic cross-sectional view illustrating another configuration example of the communication path 14. As illustrated in FIG. 19, the communication path 14 may be located in the actuating region 100. In this case, the communication path 14 may be composed of only a portion corresponding to the above-described through hole 141a (see, for example, FIG. 8). In FIG. 19, the clump-shaped body 51 is in a floating state floating from the upper surface of the second member 20, but the clump-shaped body 51 may be in contact with the upper surface of the second member 20.

An example of a method for manufacturing the heat dissipation device 1 according to the embodiment is described. First, respective green sheets are formed by a doctor blade method or a roll compaction method using respective materials of the first member 10, the second member 20 and the intermediate member 30. Then, by layering a plurality of the respective green sheets, a laminate body is obtained.

Subsequently, the obtained laminate body is subjected to laser processing or die punching, thereby obtaining the respective compacts of the first member 10, the second member 20 and the intermediate member 30. For example, a compact of the intermediate member 30 with through holes 141c, 151c, a plurality of vapor holes 36, and a plurality of reflux holes 37 can be obtained by applying laser processing to the laminate body. By applying laser processing to the resulting laminate body, a compact of the first member 10 in which the through holes 141a, 151a and the first groove forming region 110 are formed is obtained. By applying laser processing to the resulting laminate body, a compact of the second member 20 with the recessed portions 141b, 151b, the grooves 142b, 152b, and the second groove forming region 120 is obtained.

Subsequently, the compacts of the first member 10, the second member 20, and the intermediate member 30 are respectively stacked and fired in the order of the second member 20, the intermediate member 30, and the first member 10 to obtain a sintered body of the container 2 in which the first member 10, the second member 20, and the intermediate member 30 are integrated. In this way, the first member 10, the second member 20 and the intermediate member 30 are integrally formed. Since no adhesive or the like is necessary, the highly reliable heat dissipation device 1 can be obtained.

The method of obtaining the respective compacts of the first member 10, the second member 20, and the intermediate member 30 is not limited to the method described above. For example, the green sheets may be processed and then stacked to obtain the compacts. In the above example, the compact of the container 2 is obtained by fabricating the respective compacts of the first member 10, the second member 20, and the intermediate member 30 individually and then stacking them. Alternatively, the compact of the container 2 may be obtained by sequentially stacking processed green sheets, for example.

Subsequently, the actuating fluid is injected into the sintered body from one of the communication paths 14, 15, for example. The gas present in the sintered body is discharged to the outside from the other of the communication paths 14, 15, in accordance with injection of the actuating fluid.

Subsequently, a vacuum pump or other pressure reducing device is used to evacuate the inside of the sintered body through the communication paths 14, 15. The interior of the sintered body is desirably in a vacuum, but it does not have to be in a strict vacuum state and, for example, may be under reduced pressure close to a vacuum state.

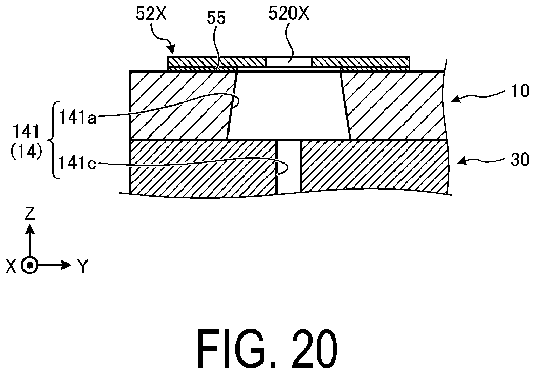

Subsequently, the communication paths 14, 15 are sealed in a state in which the inside of the sintered body is evacuated. This sealing process is described with reference to FIGs. 20 to 22. FIGs. 20 to 22 are explanatory views for explaining an example of the sealing process.

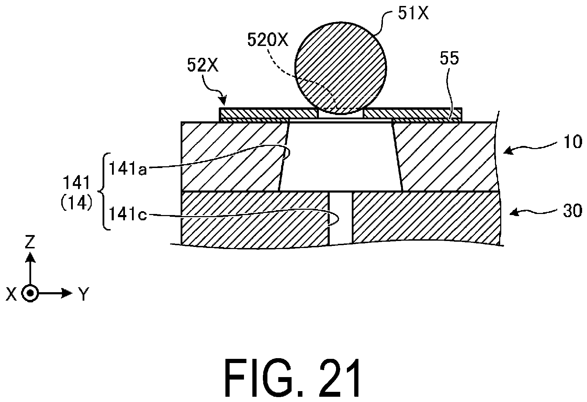

First, an annular body before press-fitting 52X illustrated in FIG. 20 and a clump-shaped body before press-fitting 51X illustrated in FIG. 21 are prepared. The annular body before press-fitting 52X is made of, for example, a thin sheet metal having an opening 520X at the center portion thereof. For example, a metal washer can be used as such an annular body before press-fitting 52X. The clump-shaped body before press-fitting 51X is, for example, a spherical metal body. The diameter of the clump-shaped body before press-fitting 51X is larger than the diameter of the opening 520X and smaller than the diameter of the communication path 14.

As illustrated in FIG. 20, the annular body before press-fitting 52X is bonded to the upper surface of the first member 10 via the bonding layer 55. The annular body before press-fitting 52X is mounted on the upper surface of the first member 10 such that the center of the opening 520X coincides with the center of the through hole 141a in the communication path 14. The diameter of the opening 520X is smaller than the diameter of the through hole 141a, and a portion of the annular body before press-fitting 52X located on the opening 520X side extends further inward in the radial direction of the communication path 14 than the opening edge of the communication path 14. The bonding layer 55 is not provided at a portion of the annular body before press-fitting 52X extending further inward in the radial direction of the communication path 14 from the opening edge of the communication path 14.

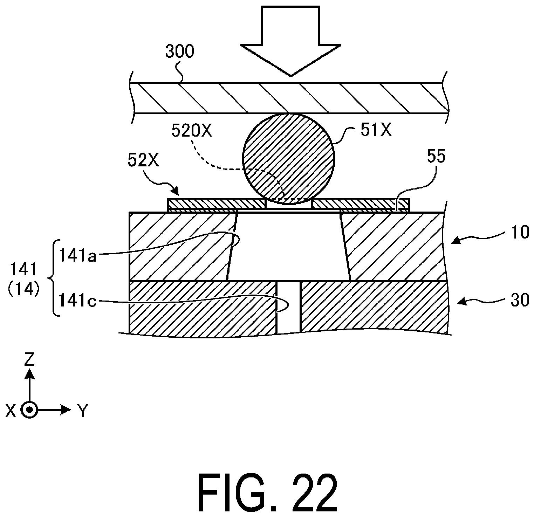

Subsequently, as illustrated in FIG. 21, the clump-shaped body before press-fitting 52X is mounted on the opening 520X of the annular body before press-fitting 51X Then, as illustrated in FIG. 22, the clump-shaped body before press-fitting 51X is pressed from above the clump-shaped body before press-fitting 51X using, for example, a press device 300. Accordingly, the clump-shaped body before press-fitting 51X is press-fitted into the through hole 141a. The annular body before press-sitting 52X is deformed so that the periphery of the opening 520X is bent toward the inside of the through hole 141a in accordance with the press fitting of the clump-shaped body before press-fitting 51X As a result, the annular body before press-fitting 52X becomes the annular body 52 having the first portion 521 and the second portion 522. The clump-shaped body before press-fitting 51X becomes the clump-shaped body 51 having the flat surface 512 when the upper end portion is pressed against the press surface of the press device 300. The clump-shaped body before press-fitting 51X becomes the clump-shaped body 51 having the flat surface 511 when press-fitted until it contacts the upper surface of the intermediate member 30.

During press-fitting into the through hole 141a, the clump-shaped body before press-fitting 51X rubs against the annular body before press-fitting 52X while applying stress thereto. This allows the clump-shaped body before press-fitting 51X to be bonded to the annular body before press-fitting 52X without any gap. That is, the clump-shaped body 51 and the annular body 52 are physically integrated. In this way, the communication paths 14, 15 are sealed by the sealing portion 5, and the heat dissipation device 1 is obtained.

### Example

A heat dissipation device was manufactured by the above-described manufacturing method using alumina for the first, second, and third members, and using Cu (copper) for the annular body and the annular body. The dimensions of the manufactured heat dissipation device (hereinafter referred to as the " heat dissipation device according to the example ") were as follows:
External dimensions (width x length x thickness): 50 mm x 50 mm x 0. 5 mm
Width of the frame region located outside the groove forming region: 10 mm
Opening diameter of through hole: 1.7 mm
Dimensions (outer diameter x inner diameter x thickness) of the annular body before press-fitting: 8 mm x 0.9 mm x 0.2 mm
Outer diameter of the clump-shaped body before press-fitting: 1.2 mm

The sealing characteristic of the heat dissipation device according to the example was tested. Specifically, the heat dissipation device according to the example was left in a vacuum for a predetermined period of time (several days), and the presence or absence of weight changes before and after being left was checked. As a result, the heat dissipation device according to the example did not show any change in weight before and after being left in a vacuum. This means that the actuating fluid located in the internal space of the heat dissipation device did not leak out of the heat dissipation device. This result confirmed that the reliable sealing characteristic is ensured for the heat dissipation device according to the example.

### First Variation

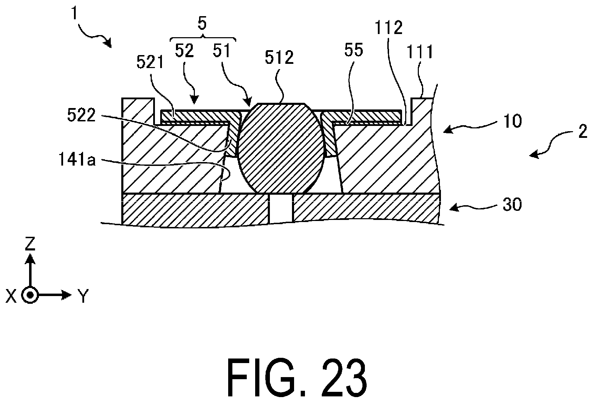

FIG. 23 is a schematic cross-sectional view illustrating the configuration of a heat dissipation device 1 according to a first variation. As illustrated in FIG. 23, the container 2 of the heat dissipation device 1 may have a depression surface 112 on an upper surface 111 (fifth surface) of the first member 10. In this case, the through hole 141a (an example of the opening portion) may be open to the depression surface 112. In addition, the first portion 521 of the annular body 52 which is a part of the flange may be located on the depression surface 112. Such a configuration can make the heat dissipation device 1 thinner. In this case, the flat surface 512 of the sealing portion 5 (the side of the sealing portion 5 that protrudes most from the depression surface 112) may be lower than the upper surface 111 of the first member 10. Such a configuration can provide an even thinner heat dissipation device 1.

### Second Variation

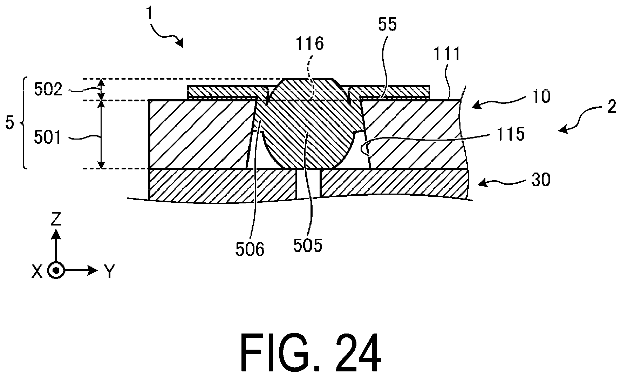

In the embodiment described above, the example in which the sealing portion 5 includes two members including the clump-shaped body 51 and the annular body 52, but the sealing portion 5 may be a single member. Such an example is described with reference to FIG. 24. FIG. 24 is a schematic cross-sectional view illustrating the configuration of a heat dissipation device 1 according to a second variation.

As illustrated in FIG. 24, the sealing portion 5 of the heat dissipation device 1 includes a core portion 501 and a flange 502 connected to the core portion 501. In the sealing portion 5, the core portion 501 is a portion located inside an opening portion 115, and the flange 502 is a portion of located outside the opening portion 115. A boundary between the core portion 501 and the flange 502 is defined as an edge 116 of the opening portion 115. That is, in FIG. 24, the portion located below the edge 116 of the opening portion 115 is the core portion 501, and the portion located above it is the flange 502.

The flange 502 is bonded to the container 2 around the opening portion 115. Specifically, the flange 502 is bonded to the upper surface 111 of the container 2 located around the opening portion 115 via the bonding layer 55.

A part of the core portion 501 is in contact with the wall surface of the opening portion 115. Specifically, the core portion 501 includes a body portion 505 and a large-diameter portion 506 located over the entire circumference of the body portion 505 and connected to the flange 502. The large-diameter portion 506 is connected to the flange 502 over the entire circumference.

Although the above-described embodiment is an example in which the through holes 141a, 151a are tapered, the shape of the through holes 141a, 151a are not limited to the tapered shape. For example, the through holes 141a, 151a may have a straight shape with a substantially constant diameter.

In the above-described embodiment, the example in which the clump-shaped body 51 is substantially spherical, but the clump-shaped body 51 is not necessarily spherical. For example, the clump-shaped body 51 may be wedge-shaped, that is, the clump-shaped body 51 may be progressively narrower from a first end portion exposed to the outside of the heat dissipation device 1 (here, the upper end portion of the clump-shaped body 51) to a second end portion located inside the communication path 14 (here, the lower end portion of the clump-shaped body 51).

As described above, the thermal device (for example, the heat dissipation device 1) according to the embodiment is a thermal device that utilizes the latent heat of a phase transformation substance (for example, the actuating fluid). The thermal device according to the embodiment includes a ceramic container (for example, the container 2) and a sealing portion (for example, the sealing portion 5). The ceramic container includes a phase transformation region (for example, the actuating region 100) in which a phase transformation substance is sealed, and communication paths (for example, the communication paths 14, 15) configured to connect the phase transformation region with the outside. The sealing portion blocks the communication paths. The sealing portion includes a metal annular body (for example, the annular body 52) and a clump-shaped body (for example, the clump-shaped body 51). The annular body has an opening having a diameter smaller than that of the communication path, and is located on the container so that the opening overlaps the communication path. The clump-shaped body is located inward of the annular body in the radial direction of the communication path, is in contact with the annular body over the entire circumference, and is integrated with the annular body at a contact portion.

Thus, the thermal device according to the embodiment can enhance the sealing characteristic.

The thermal device according to the present disclosure is not limited to the heat dissipation device. For example, the thermal device according to the present disclosure may be a thermal storage device that stores latent heat associated with phase transformation of a thermal storage material (an example of the phase transformation substance) as thermal energy. In that case, a material that performs solid-liquid phase transformation or a material that performs solid-solid phase transformation is used as the heat storage material. Thus, the phase transformation substance is not necessarily required to undergo gas-liquid phase transformation. In other words, the phase transformation substance is not necessarily liquid, but may be solid.

Note that the embodiments disclosed herein are exemplary in all respects and not restrictive. The aforementioned embodiments can be embodied in a variety of forms. The above-described embodiments may be omitted, substituted or modified in various forms without departing from the scope and spirit of the appended claims.

### REFERENCE SIGNS

1 Heat dissipation device
5 Sealing portion
10 First member
11 First groove portion
11a First recessed portion
1 1b First protruding portion
14,15 Communication path
20 Second member
21 Second groove portion
21a Second recessed portion
21b Second protruding portion
30 Intermediate member
36 Vapor hole
37 Reflux hole
51 Clump-shaped body
52 Annular body
100 Actuating region
141 First portion
141a Through hole, First path
141b Recessed portion
141c Through hole, Second path
142 Second portion
142a Individual path
200 Frame region
501 Core portion
502 Flange
520 Opening

## Claims

1. A thermal device comprising:
a ceramic container comprising an internal space, an opening portion connected to the internal space, and a communication path configured to connect the internal space and the opening portion;
a fluid located in the internal space; and
a sealing portion configured to block the opening portion, wherein
the sealing portion comprises a core portion and a flange connected to the core portion,
the flange is bonded to the container around the opening portion,
the core portion is located in the opening portion, and
a portion of the core portion is in contact with a wall surface of the opening portion.

2. The thermal device according to claim 1, wherein
the flange is bonded to the container via a bonding layer made of a metal.

3. The thermal device according to claim 2, wherein
the core portion comprises
a body portion, and
a large-diameter portion located over an entire circumference of the body portion and connected to the flange, and
a thickness of the large-diameter portion is less than a thickness of the flange.

4. The thermal device according to claim 3, wherein
a tip end of the large-diameter portion has a tapered shape.

5. The thermal device according to any one of claims 1 to 4, wherein
the sealing portion is separated from an edge of the opening portion.

6. The thermal device according to any one of claims 1 to 5, wherein
the sealing portion has a recessed portion or a protruding portion on an upper surface thereof.

7. The thermal device according to any one of claims 1 to 6, wherein
the container comprises a main surface and a depression surface depressed with respect to the main surface,
the opening portion opens to the depression surface, and
the flange is located on the depression surface.

8. The thermal device according to any one of claims 1 to 7, wherein
the container comprises
an intermediate member having a plate shape and comprising a plurality of reflux holes extending through a first surface and a second surface located on an opposite side of the first surface,
a first member comprising a first groove portion on a third surface facing the first surface of the intermediate member, and
a second member comprising a second groove portion on a fourth surface facing the second surface of the intermediate member.

9. The thermal device according to any one of claims 1 to 8, wherein
the communication path comprises
a first path connected to the opening portion, and
a second path connected to the first path and located on the internal space side,
a diameter of the second path is smaller than a diameter of the first path, and
the second path is blocked by the core portion.

10. The thermal device according to claim 9, wherein
a portion of the core portion enters the second path.

11. The thermal device according to any one of claims 1 to 10, wherein
the communication path comprises a tapered portion in a cross-sectional view.
